# EUROPEAN PATENT SPECIFICATION

(11) **EP 2 924 828 B1**
(45) Date of publication and mention of the grant of the patent: **22.06.2022**
(21) Application number: 14290079.4
(22) Date of filing: 26.03.2014
(51) Int. Cl.: H02G 3/08, H02G 15/007, H02G 3/22

(54) **Removable cable inlet**
Abnehmbare Kabeleinführung
Entrée de câble amovible

(43) Date of publication of application: 30.09.2015
(73) Proprietor: CONNECTEURS ELECTRIQUES DEUTSCH, 27091 Evreux Cedex 9 (FR)
(72) Inventor: Houvenaghel, Fabien, 27000 Evreux (FR); Quin, Didier, 27600 St Julien (FR); Cavailles, Christian, 27930 Gravigny (FR)
(74) Representative: Grünecker Patent- und Rechtsanwälte PartG mbB

(56) References cited:
- WO-A1-2012/007065
- DE-C1- 19 908 657
- US-A- 3 732 527
- US-A- 5 908 180
- US-A1- 2010 279 530
- US-B1- 6 521 833

## Description

The present invention relates to an enclosure assembly comprising a housing body and at least one removable cable inlet comprising a conductive chimney for leading wire beams.

Enclosure assemblies are commonly used for surrounding electrical components, such as electrical lines, terminals attached thereto and electronic devices, e.g. filters, in order to protect them against detrimental environmental influences, such as shock, dirt and moisture. Especially the aerospace industry demands high standards in providing said protection. Therefore, electrical connectors have enclosure assemblies comprising housing bodies providing an interior space and cable inlets for leading wire beams in such housing bodies for accommodating the electrical component.

The cable inlets comprising chimneys and different accessories are known from the prior art. They are commonly mounted onto or into housing bodies to form enclosure assemblies via mating interface regions.

Examples of commonly used cable inlets can, for example, be found in WO 2012/007065 A1, US 5908180 A, DE 19908657 C1, US 3732527 A, US 6521833 B1 and US 2010/0279530. Document WO2012/007065A1 discloses an enclosure assembly according to the preamble of claim 1.

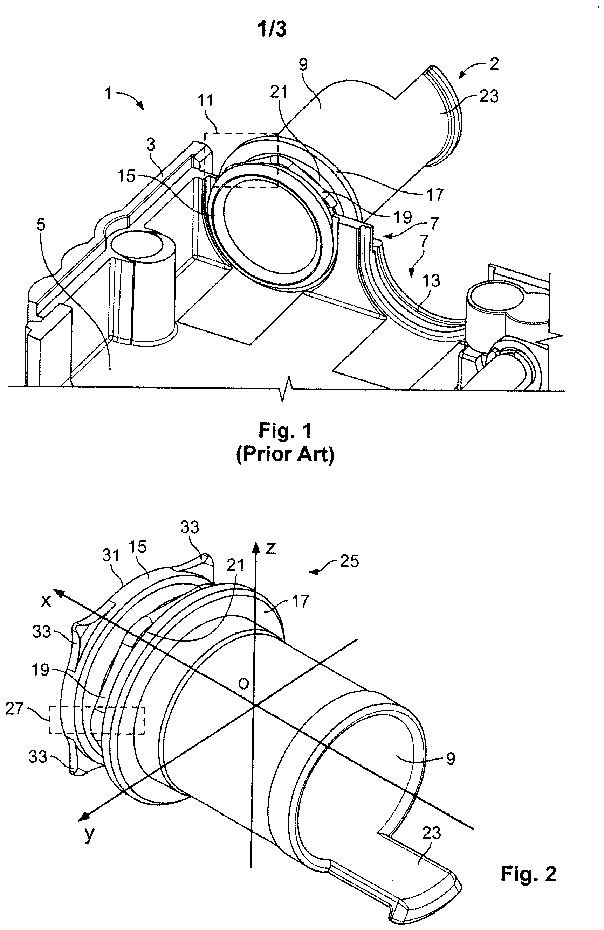

Fig. 1 shows an enclosure assembly 1, known from the prior art, comprising a housing body 3, which has an interior surface 5 covered by a conductive plating, e.g. nickel, and one or more openings 7 on at least one of its sides, for receiving one or more removable cable inlets 2. The housing body 3 can be closed with a cover which is not shown in figure 1 and which also has a conductive plating, which is not shown in fig. 1. The cable inlet 2 comprises a chimney 9 for leading wire beams (not shown) into the housing body 3. The chimney 9 comprises on its one extremity an interface region 11 for mounting the cable inlet 2 onto or into a mating interface region 13 defining the openings 7 of the housing body 3. The interface region 11 of the chimney 9 comprises connection collars 15, 17 permitting to fix the chimney 9 to the housing body 3 by a form-fitted connection. The chimney 9 is typically made of a metallic material, e.g. stainless steal or aluminum.

A metallic resilient means 19 for ensuring an electric connection between the housing body 3 and the chimney 9 is furthermore provided in a groove 21 provided in the interface region 11. A tie-wrap receiving section 23 is provided on the opposing extremity of the chimney 9.

It has, however, been observed that the plating on the internal surface of the housing body was worn off close to the interface mating region 13. Thus there is a risk that an interruption of the electric continuity between the chimney 9 and the housing body 3 could occur.

In view of the observed problem, it is an object of the present invention to provide an improved removable cable inlet which better protects the interior surface region of the housing body against wear.

This object is achieved by an enclosure assembly comprising a housing body and at least one removable cable inlet according to claim 1 of the present invention. The removable cable inlet comprises a chimney for leading wire beams with an interface region for mounting the cable inlet onto or into a mating interface region of a housing body using a form fitted connection, wherein the interface region of the chimney comprises a rotation prevention means for preventing a rotation of the chimney with respect to the housing body in the mounted state.

With the rotation prevention means, frictional forces that can occur by a relative movement in particular a rotation, between the chimney and the housing can be reduced. Thus, the rotation prevention means better protects the plating in the mating interface region of the housing body and therefore the electric continuity between the chimney and the housing can be maintained. At the same time no structural changes have to be made to the housing body.

It can be preferred, according to any embodiments above and below, that the interface region of the chimney comprises a portion with a rotational symmetry, in particular a cylindrical portion. The cylindrical portion of the interface region of the chimney allows a better and easier assembly when fixing the cable inlet onto or into the housing body. The rotation prevention means of the interface region has a non-circular shape in the plane (yOz) perpendicular to the rotation axis (Ox). The non-circular rotation prevention means with a non-circular shape in the plane (yOz) reduces the risk of plating degradation without having to change the geometry of the housing body, and more particularly on the mating interface region of the housing body.

It can be further preferred, according to any embodiments above and below, that the non-circular rotation prevention means has a three or four or five or six fold symmetry. Thus the cable inlet can be fixed to the housing body in a plurality of arrangements.

The non-circular rotation prevention means comprises protruding portions in the plane (yOz) perpendicular to the rotation axis (Ox). According to any embodiments above and below, that the protruding portions are outwardly directed in the plane (yOz) perpendicular to the rotation axis (Ox). By adding protruding portions the rotation of the chimney with respect to the housing body can be prevented without a major change in the design of the interface region.

It is further preferred, according to any embodiments above and below, that the non-circular rotation prevention means can comprise circular elements arranged in a ring shaped manner with at least two, preferably four, protrusions arranged equidistantly from each other. Thus the cable inlet can be fixed to the housing body in a plurality of different arrangements.

It can be further preferred, according to any embodiments above and below, that the removable cable inlet further comprises a resilient means, in particular a spring for preventing movements of the cable inlet along the rotation axis when mounted. The resilient means, which is used to ensure the electric connection between the cable inlet and the housing, can no longer rotate with respect to the housing as the rotation is blocked by the rotation prevention means. Thereby, the reliability of the device can be further improved.

The protruding region has some rounded or bevel shaped edges in the plane (yOz) perpendicular to the rotation axis (Ox) and in the plane (xOz). Rounded edges help in further reducing the risk of damaging the plating, e.g. during assembly.

According to a preferred embodiment, the removable cable inlet can comprise a tie wrap receiving portion wherein the non-circular rotation prevention means and the tie wrap receiving portion are configured and arranged such that they have a predetermined position with respect to each other and in particular in the mounted state of the removable cable inlet in the housing body the tie wrap receiving portion is essentially parallel to one of the housing body's surfaces. This facilitates the work of technicians or engineers when realizing the cabling.

According to a preferred embodiment, the removable cable inlet can comprise a non-circular rotation prevention means with rotation preventing elements with rectilinear edges in the plane perpendicular to the rotation axis. When mount into a housing body the rectilinear edges can prevent the rotation of a neighbouring cable inlet when positioned on the rotation trajectory of the neighbouring cable inlet and thereby protect the surface properties of the housing body.

Further, the present invention relates to an enclosure assembly comprising a housing body and at least one removable cable inlet according to any one of the embodiments cited above with the interface region being mounted onto or into the mating interface region for leading wire beams from outside the housing into the interior space of the housing body.

It can be further preferred, according to any embodiments above and below, that the non-circular rotation prevention means of the removable cable inlet can be placed inside the housing body and/or at the extremity of the interface region outside the housing body. Placing the non-circular rotation prevention means inside has the advantage that the outside shape of the assembly does not change; positioning it outside has the advantage that the internally available volume does not change. Having rotation prevention means both inside and outside further improves the longevity of the device.

The mating interface region of the housing body comprises a circular segment that extends essentially over the same angular region as the circular element of the non-circular rotation prevention means. Thereby, the protrusions at the extremities of the circular segment of the chimney can inhibit a relative movement.

According to a preferred embodiment, the enclosure assembly can comprise at least two removable cable inlets mounted onto or into two adjacent mating interface regions characterized in that the non circular rotation prevention means of the adjacent removable cable inlets are configured and arranged such that the non circular rotation prevention means of the one cable inlet is placed at least partially on the rotation trajectory of the non circular rotation prevention means of the other cable inlet. Thus the rotation prevention and thereby the protection of the plating of the housing body is assured by the two non circular rotation prevention means which are positioned on the rotation trajectory around the rotation axis of the cable inlet of the other cable inlet and therefore independent of the design of the housing body.

The invention will be described in more details by way of example hereinafter using advantageous embodiments and with reference to accompanying drawings. The described embodiments are only possible for configurations in which individual features may be implemented independently of each other or may be omitted. Equal elements illustrated in the drawings are provided with equal reference signs.
Fig. 1 is a schematic cross-sectional view of a cable inlet mounted in a housing body disclosed in the prior art;
Fig. 2 is a schematic perspective view of a cable inlet according to a first embodiment of the present invention exhibiting different plans of the cable inlet;
Fig. 3 is a schematic cross-sectional view of the non-circular rotation prevention means according to some embodiments of the present invention;
Fig. 4 is a view of details of the interface region of a cable inlet according to some embodiments of the present invention;
Fig. 5 is a schematic perspective view of a removable cable inlet mounted onto a housing body according to a second embodiment of the present invention;
Fig. 6 is a schematic perspective view of a removable cable inlet mounted onto a housing body according to a non-claimed exemplary embodiment of the present invention;

A removable cable inlet 25 according to a first embodiment of the invention is described in the following with reference to schematic perspective view of Fig. 2. Elements with reference numerals already used in Figure 1 will not be described in detail again, but reference is made to their description above. A longitudinal direction x, a transversal direction y and a height direction z is assigned to the cable inlet 25, in order to fully understand the present invention. The longitudinal direction x, the transversal direction y and the height direction z are extending perpendicular with respect to each other such that they may be regarded as a Cartesian coordinate system.

The removable cable inlet 25 according to the first embodiment comprises a chimney 9, and an interface region 27 on one extremity of the chimney 9.

The chimney 9 in this embodiment has a cylindrical shape and can be made out of a conductor, e.g. a metal like aluminum or an alloy like stainless steal. Moreover, the chimney 9 comprises at its second extremity a tie wrap receiving portion 23 such that a wire beam can be attached to the chimney 9 using a tie wrap as known in the art. The tie wrap receiving portion 23 is in the extension of the chimney 9.

The interface region 27 comprises first and second connection collars 15, 17 and between the two collars a groove 21 with a resilient means 19. The resilient means 19 in this embodiment is a metallic spring, in particular made of nickel.

The interface region 27 furthermore comprises a non-circular rotation prevention means 31, which in this embodiment is arranged on the first connection collar 15 and comprises a plurality of protrusions 33.

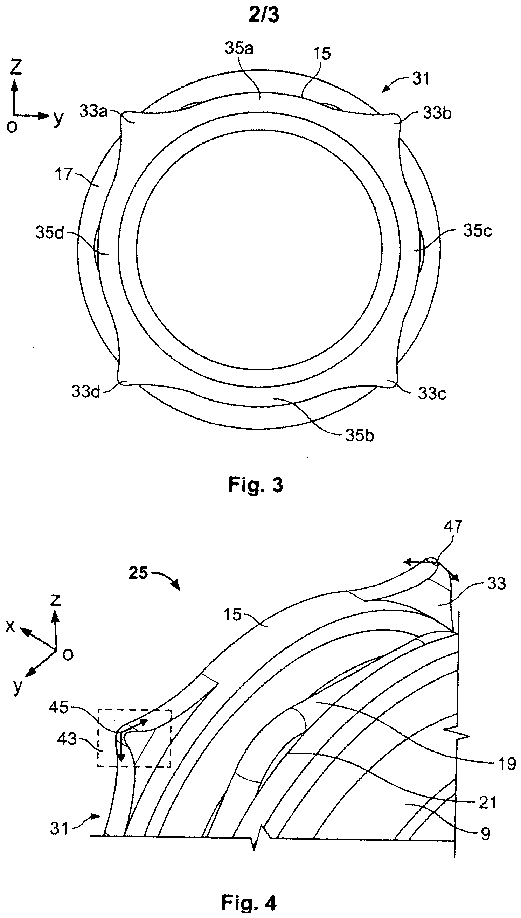

Figure 3 shows a schematic view of the non-circular rotation prevention means 31 and the connection collars 15 and 17 along the axis (Ox) of Figure 2. The rotation prevention means 31 of the interface region 27 is essentially arranged in the plane (yOz) thus perpendicular to the axis (Ox) corresponding to the rotational symmetry axis of the chimney 9. As can be seen in the Figure 3, the four protrusions 33a, 33b, 33c, 33d are arranged such that they point outwardly. A circular or ring shaped segment 35a, 35b, 35c, 35d is arranged between two adjacent protrusions 33a, 33b, 33c, 33d. They actually are part of the connection collar 15 of the prior art. In this embodiment, each segment 35a, 35b, 35c, 35d has the same size, i.e. covers the same angular range. Thus the non circular rotation prevention means 31 of this embodiment has a four fold symmetry when looking along axis (Ox).

According to variants, the non-circular prevention means 31 may have a two, three, five, six or more fold symmetry with at least two protruding portions 33 in the plane (yOz) of the non-circular prevention rotation means 31.

Fig. 4 exhibits a view of the details of the protrusions of the interface region 27 of a cable inlet 25 as shown in Fig. 2 according to the first embodiment of the present invention. The protrusions 33a, 33b, 33c and 33d of the non-circular rotation prevention means 31 have rounded edges 45, 47 both in the plane (yOz) perpendicular to the rotation axis (Ox) and in the plane (xOz). According to a variant the edges could also be beveled.

In this embodiment, the non-circular rotation prevention means 31 is positioned at the first connection collar 15 at the utmost extremity of the interface region 27. According to further variants of this embodiment, the non-circular rotation prevention means could be positioned at the second connection collar 17 or even at both the first and second connection collar 15 and 17.

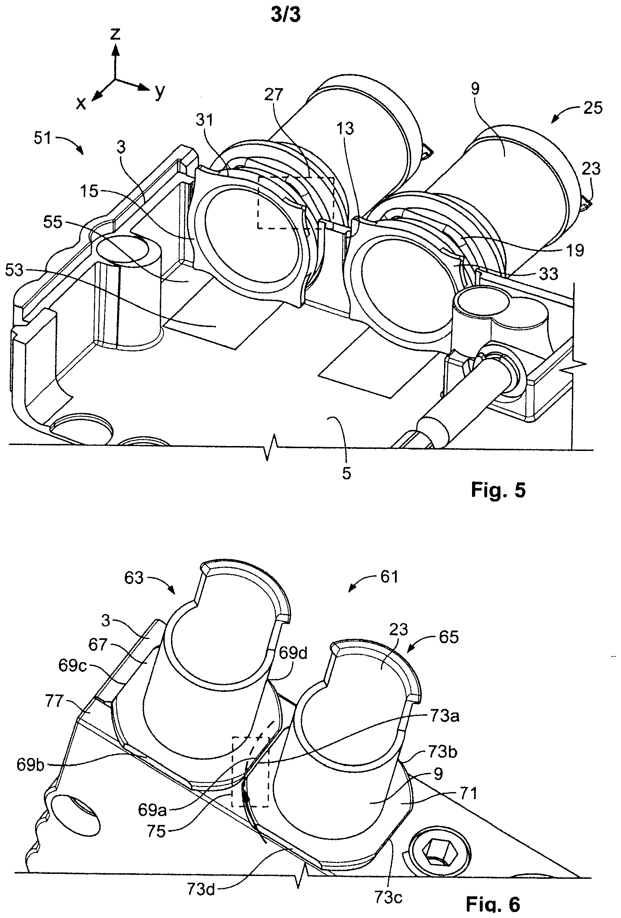

Like it will be described in the following in relation to Figure 5, the non-circular rotation prevention means 31 of the first embodiment and its further variants is advantageously used in connector assemblies for preventing the rotation of the removable cable inlet 25 with respect to a housing body 3 to protect the plating on the interior surface 5 of the housing body 3.

Fig. 5 illustrates schematically a part of an enclosure assembly 51 according to a second embodiment of the present invention. The enclosure assembly 51 comprises a housing body 3 with one or more openings 7 each having a mating interface region 13 configured to host one cable inlet 25 according to the first embodiment of the invention or one of its variants. The housing body 3 is still open but can be closed with a cover also having a mating interface region to completely enclose the interface region 27 of the cable inlet 25. The housing body 3 is positioned in a Cartesian coordinate system xyz such that its sidewalls comprising bottom and top side walls are aligned with the planes (xOy), (yOz) and (xOz). Elements having reference numerals already used in the description of the prior art or the first embodiment will not be described in detail but reference is made to their description above.

In Figure 5, two mating interface regions 13 are visible and one removable cable inlet 25 is mounted with its interface region 27 into one of the two mating interface regions 13. The first and second connection collars 15 are 17 together with the resilient means 19 are positioned such that they are sandwiching the side wall of the housing body 3 such that a form fitted connection is achieved between the housing body 3 and the cable inlet 25 in the direction (Ox) as defined in Figure 2. At the same time due to the resilient means 19, the electrical connection between the housing body 3 and the cable inlet 25 is assured.

In this variant of the cable inlet 25, the non-circular rotation prevention means 31 with its protrusions 33 is positioned inside the housing body 3 in the mounted state. According to the variants described above, such protrusions could instead or in addition be positioned outside the housing body 3, e.g. at the second connection collar 17.

The ring segment 35d of the non-circular rotation prevention means 31 is positioned in a mating circular segment 53 on the bottom surface 55 of the housing body 3 which is essentially flat on both sides of the mating circular segment 53. As can be seen, both segments 35d and 53 cover the same angular range such that the protrusions 33d and 33c come to rest on the flat part of the bottom surface 55 of the housing body 3.

As a consequence rotational movements around axis (Ox) of the cable inlet 25 (see Figure 2) can effectively reduced as the rotational symmetry of the prior art cable inlet is broken. As a consequence frictional forces which occurred in the prior art assembly due to rotational movements between the cable inlet and the housing bodies can be suppressed at least to a great extent. In particular, the resilient means 19 can no longer damage the plating. As a consequence, the lifetime of the enclosure assembly 51 is superior to the one of the prior art.

As the cover of the housing body has a similar mating interface region, the same effect can be observed at the interface between cover and cable inlet 25.

Figure 5 furthermore illustrates that the tie-wrap receiving portion 23 is arranged such that in the mounted state of the cable inlet 25, the receiving portion 23 is in a predetermined position, here aligned with plane (xOz). The cable inlet 25 could also be mounted in a different manner into the housing body, namely by turning it by 90°, 180° or 270° around (Ox). Thus four different predetermined positions for the tie-wrap receiving portion are available for this embodiment. General speaking the tie wrap receiving portion 23 can be aligned with the bottom surface 55, the top surface (not shown) or the sidewalls of the housing body 3. In case of more or less protrusions 33 on the non-circular rotation prevention means more predetermined positions would be available.

Fig. 6 presents a three dimensional partial view of an enclosure assembly 61 according to a non-claimed third embodiment of the present invention. Elements having reference numerals already used in the description of the prior art or the first embodiment will not be described in detail but reference is made to their description above.

The enclosure assembly 61 comprises a housing body 3, at least two removable cable inlets 63, 65 and a cover 77 to close the housing body 3 and to fix the cable inlets 63 and 65.

The removable cable inlets 63 and 65 according to the third embodiment comprise the cylindrical chimney 9 like in the first and second embodiment but different non-circular rotation prevention means 67 and 71. In this embodiment the non-circular rotation prevention means 67 and 71 are positioned outside the housing body 3 but could also be inside the housing body instead or in addition.

In the third embodiment, the prevention of the rotation of the cable inlet 63 and 65 with respect to the housing body 3 and/or the cover 77 is prevented by placing first rotation preventing elements 69a or 69b or 69c or 69d of the first non-circular rotation prevention means 67 of the first cable inlet 63 onto the rotation trajectory 75 (in dotted lines) of the second non-circular rotation prevention means 71 around its rotation axis and vice versa by placing second rotation preventing elements 73a or 73b or 73c or 73d of the second non-circular rotation prevention means 71 of the second cable inlet 65 onto the rotation trajectory 75 of the first non-circular rotation prevention means 71 around its rotation axis.

The rotation preventing elements 69a-d and 73a-d in this embodiment are formed as rectilinear edges on the connection collar of the interface regions in the planes perpendicular to the rotation axis (Ox) of the cable inlets 63 and 65, which, in the mounted state of the cable inlets 63 and 65, lay next to each other to prevent the rotation. Other shapes of the neighbouring edges are suitable to have the same effect.

Unlike in the first and second embodiment the rotation is not prevented by an interaction between the cable inlet 25 and the housing body 3 but by the shapes of the two neighbouring cable inlets 63 and 65 and thus independent of the design of the housing.

The features of the various embodiments and their variants can be combined to form further embodiments according to the invention and suitable to protect the surface properties, in particular the plating, of the housing.

### List of references

1 enclosure assembly (prior art)
2 removable cable inlet (prior art)
3 housing body
5 interior surface of the housing body
7 openings
9 chimney
11 interface region (prior art)
13 mating interface region
15 connection collar/ring
17 connection collar/ring
19 resilient means
21 groove
23 tie-wrap receiving section
25 removable cable inlet according to the invention (first embodiment)
27 interface region
31 non-circular rotation prevention means
33a, 33b, 33c, 33d protrusions/protruding portions
35a, 35b, 35c, 35d circular/ring segment
43 protruding region
45 round shaped edges
47 round shaped edges
51 enclosure assembly (2nd embodiment)
53 mating circular segment
55 bottom surface of housing body
61 enclosure assembly (3rd embodiment)
63 first cable inlet
65 second cable inlet
67 first non circular rotation prevention means
69a, 69b, 69c, 69d first rotation preventing elements
71 second non circular rotation prevention means
73a, 73b, 73c, 73d second rotation preventing elements
75 rotation trajectory
77 cover

## Claims

1. An enclosure assembly comprising a housing body (3) and at least one removable cable inlet (25), said removable cable inlet comprising a chimney (9) for leading wire beams with an interface region (11) for mounting the cable inlet onto or into a mating interface region (13) of the housing body (3) using a form fitted connection (3), wherein the interface region (11) of the chimney (9) comprises a rotation prevention means (31) for preventing a rotation of the chimney (9) with respect to the housing body (3) in the mounted state, and
wherein the rotation prevention means (31) of the interface region has a non-circular shape in the plane (yOz) perpendicular to the rotation axis (Ox) corresponding to the rotational symmetry axis of the chimney (9),
**characterized in that**
the chimney (9) is conductive,
the housing body (3) has an interior surface covered by a conductive plating,
the non-circular rotation prevention means (31) comprises protruding portions (33) outwardly directed in the plane (yOz) perpendicular to the rotation axis (Ox), and **in that** each said protruding portion (11) has rounded or bevel shaped edges in the plane (yOz) perpendicular to the rotation axis (Ox) and in the plane (xOz) comprising the rotation axis (Ox) such that the protruding portions (33) come to rest on a flat part of a bottom surface (55) of the housing body (3),
and wherein said non-circular rotation prevention means (31) comprises circular elements (15) arranged in a ring shaped manner with at least two said protruding portions (33) arranged equidistantly from each other,
and **in that** the mating interface region (13) of the housing body (3) has a circular segment (53) on the bottom surface (55) that extends essentially over the same angular region as a circular element of the non-circular rotation prevention means (31).

2. An enclosure assembly according to claim 1, **characterized in that** the interface region (11) of the chimney (9) comprises a portion with a rotational symmetry, in particular a cylindrical portion.

3. An enclosure assembly according to claim 1 or 2, **characterized in that** the non-circular rotation prevention means (31) has a three or four or five or six fold symmetry

4. An enclosure assembly according to any of claims 1 to 3, **characterized in that** the non-circular rotation prevention means (31) comprises said circular elements (15) arranged in a ring shaped manner with four of said protrusions (33) arranged equidistantly from each other

5. An enclosure assembly according to any of claims 1 to 4, **characterized in** further comprising a resilient means (19), in particular a spring.

6. An enclosure assembly further comprising a tie wrap receiving portion (23), **characterized in that** the non-circular rotation prevention means (31) and the tie wrap receiving portion (23) are configured and arranged such that they have a predetermined position with respect to each other and in particular in the mounted state of the removable cable inlet in the housing body (3) the tie wrap receiving portion is essentially parallel to one of the housing body's surfaces.

7. An enclosure assembly according to one of claims 1 to 6, **characterized in that** the non-circular rotation prevention means (67) comprises rotation preventing elements (69a, 69b, 69c, 69d) with rectilinear edges in the plane perpendicular to the rotation axis (0x).

8. An enclosure assembly according to any one of claims 1 to 7 with the interface region (11) of the cable inlet (25) being mounted onto or into the mating interface region (13) of the housing for leading wire beams from outside the housing into the interior space of the housing body (3).

9. An enclosure assembly according to one of the preceding claims, **characterized in that** the non-circular rotation prevention means (31) of the removable cable inlet (25) is positioned inside the housing body (3) and/or at the extremity of the interface region outside the housing body (3).

10. An enclosure assembly according to one of one of the preceding claims with at least two of said removable cable inlets (63, 65) mounted onto or into two adjacent mating interface regions (13) **characterized in that** the non circular rotation prevention means (67, 71) of the adjacent removable cable inlets (63, 65) are configured and arranged such that the non circular rotation prevention means (67) of the one cable inlet (63) is placed at least partially on the rotation trajectory (75) of the non circular rotation prevention means (71) of the other cable inlet (65).

## Patentansprüche

1. Gehäusebaugruppe, die einen Gehäusekörper (3) und wenigstens einen abnehmbaren Kabeleinlass (25) umfasst, wobei der abnehmbare Kabeleinlass einen Dom (9) zum Führen von Drahtträgern mit einem Schnittstellenbereich (11) zum Montieren des Kabeleinlasses an oder in einem Gegen-Schnittstellenbereich (13) des Gehäusekörpers (3) unter Verwendung einer formschlüssigen Verbindung (3) umfasst, der Schnittstellenbereich (11) des Doms (9) eine Einrichtung (31) zur Verhinderung von Drehung umfasst, mit der eine Drehung des Doms (9) in Bezug auf den Gehäusekörper (3) in dem montierten Zustand verhindert wird, und
die Einrichtung (31) zur Verhinderung von Drehung des Schnittstellenbereiches eine nicht kreisrunde Form in der Ebene (yOz) senkrecht zu der Drehachse (Ox) hat, die der Drehsymmetrie-Achse des Doms (9) entspricht,
**dadurch gekennzeichnet, dass** der Dom (9) leitend ist, der Gehäusekörper (3) eine mit einer leitenden Beschichtung überzogene Innenfläche aufweist,
die nicht kreisrunde Einrichtung (31) zur Verhinderung von Drehung vorstehende Abschnitte (33) umfasst, die in der Ebene (yOz) senkrecht zu der Drehachse (Ox) nach außen gerichtet sind,
und dadurch, dass jeder vorstehende Abschnitt (11) abgerundete oder fasenförmige Kanten in der Ebene (yOz) senkrecht zu der Drehachse (Ox) und in der Ebene (xOz) aufweist, die die Drehachse (Ox) umfasst, so dass die vorstehenden Abschnitte (33) auf einem ebenen Teil einer Bodenfläche (55) des Gehäusekörpers (3) aufliegen, und wobei die nicht kreisrunde Einrichtung (31) zur Verhinderung von Drehung kreisrunde Elemente (15) umfasst, die ringförmig angeordnet sind, wobei wenigstens zwei der vorstehenden Abschnitte (33) in gleichem Abstand zueinander angeordnet sind,
und dadurch, dass der Gegen-Schnittstellenbereich (13) des Gehäusekörpers (3) ein kreisrundes Segment (53) an der Bodenfläche (55) aufweist, das sich im Wesentlichen über den gleichen Winkelbereich erstreckt wie ein kreisrundes Element der nicht kreisrunden Einrichtung (31) zur Verhinderung von Drehung.

2. Gehäusebaugruppe nach Anspruch 1, **dadurch gekennzeichnet, dass** der Grenzflächen-Bereich (11) des Doms (9) einen Abschnitt mit Drehsymmetrie, insbesondere einen zylindrischen Abschnitt, umfasst.

3. Gehäusebaugruppe nach Anspruch 1 oder 2, **dadurch gekennzeichnet, dass** die nicht kreisrunde Einrichtung (31) zur Verhinderung von Drehung eine drei- oder vier- oder fünfoder sechsfache Symmetrie aufweist.

4. Gehäusebaugruppe nach einem der Ansprüche 1 bis 3, **dadurch gekennzeichnet, dass** die nicht kreisrunde Einrichtung (31) zur Verhinderung von Drehung die kreisrunden Elemente (15) umfasst, die ringförmig angeordnet sind, wobei vier der Vorsprünge (33) in gleichem Abstand zueinander angeordnet sind.

5. Gehäusebaugruppe nach einem der Ansprüche 1 bis 4, **dadurch gekennzeichnet, dass** sie des Weiteren eine elastische Einrichtung (19), insbesondere eine Feder, umfasst.

6. Gehäusebaugruppe, die des Weiteren einen Kabelbinder-Aufnahmeabschnitt (23) umfasst, **dadurch gekennzeichnet, dass** die nicht kreisrunde Einrichtung (31) zur Verhinderung von Drehung und der Kabelbinder-Aufnahmeabschnitt (23) so ausgeführt und angeordnet sind, dass sie eine vorgegebene Position in Bezug zueinander haben, und insbesondere in dem montierten Zustand des entfernbaren Kabeleinlasses in dem Gehäusekörper (3) der Kabelbinder-Aufnahmeabschnitt im Wesentlichen parallel zu einer der Flächen des Gehäusekörpers ist.

7. Gehäusebaugruppe nach einem der Ansprüche 1 bis 6, **dadurch gekennzeichnet, dass** die nicht kreisrunde Einrichtung (67) zur Verhinderung von Drehung Elemente (69a, 69b, 69c, 69d) zum Verhindern von Drehung mit geradlinigen Kanten in der Ebene senkrecht zu der Drehachse (Ox) umfasst.

8. Gehäusebaugruppe nach einem der Ansprüche 1 bis 7, wobei der Schnittstellenbereich (11) des Kabeleinlasses (25) an oder in dem Gegen-Schnittstellenbereich (13) des Gehäuses montiert ist, um Drahtträger von außerhalb des Gehäuses in den Innenraum des Gehäusekörpers (3) hinein zu führen.

9. Gehäusebaugruppe nach einem der vorangehenden Ansprüche, **dadurch gekennzeichnet, dass** die nicht kreisrunde Einrichtung (31) zur Verhinderung von Drehung des abnehmbaren Kabeleinlasses (25) im Inneren des Gehäusekörpers (3) und/oder an dem äußersten Ende des Schnittstellenbereiches außerhalb des Gehäusekörpers (3) positioniert ist.

10. Gehäuseanordnung nach einem der vorangehenden Ansprüche, wobei wenigstens zwei der abnehmbaren Kabeleinlässe (63, 65) an oder in zwei benachbarten Gegen-Schnittstellenbereichen (13) montiert sind, **dadurch gekennzeichnet, dass** die nicht kreisrunden Einrichtungen (67, 71) zur Verhinderung von Drehung der benachbarten entfernbaren Kabeleinlässe (63, 65) so ausgeführt und angeordnet sind, dass die nicht kreisrunde Einrichtung (67) zur Verhinderung von Drehung des einen Kabeleinlasses (63) wenigstens teilweise auf der Drehbahn (75) der nicht kreisrunden Einrichtung (71) zur Verhinderung von Drehung des anderen Kabeleinlasses (65) angeordnet ist.

## Revendications

1. Ensemble formant enceinte comprenant un corps d'enveloppe (3) et au moins un orifice d'entrée de câble (25) amovible, ledit orifice d'entrée de câble amovible comprenant un conduit (9) destiné à guider des faisceaux de câbles avec une zone interface (11) pour monter l'orifice d'entrée de câble sur ou dans une zone interface appariée (13) du corps d'enveloppe (3) en utilisant une connexion de forme complémentaire (3), la zone interface (11) du conduit (9) comprenant un moyen d'interdiction de rotation (31) destiné à empêcher la rotation du conduit (9) par rapport au corps d'enveloppe (3) lorsqu'il est monté, et
dans lequel le moyen d'interdiction de rotation (31) de la zone interface présente une forme non circulaire dans le plan (yOz) perpendiculaire à l'axe de rotation (Ox) correspondant à l'axe de symétrie de rotation du conduit (9),
**caractérisé en ce que :**
le conduit (9) est conducteur,
le corps d'enveloppe (3) possède une surface intérieure recouverte par un placage conducteur,
le moyen d'interdiction de rotation (31) non circulaire comprend des parties saillantes (33) dirigées vers l'extérieur dans le plan (yOz) perpendiculaire à l'axe de rotation (Ox), et **en ce que** chacune desdites parties saillantes (33) comporte des bords de forme arrondie ou chanfreinée dans le plan (yOz) perpendiculaire à l'axe de rotation (Ox) et dans le plan (xOz) qui comprend l'axe de rotation (Ox) de sorte à ce que les parties saillantes (33) viennent reposer sur une partie plate de la surface de fond (55) du corps d'enveloppe (3),
et dans lequel ledit moyen d'interdiction de rotation (31) non circulaire comprend des éléments circulaires (15) disposés pour former un anneau comportant au moins deux desdites parties saillantes (33) disposées de façon équidistante l'une par rapport à l'autre,
et **en ce que** la zone interface appariée (13) du corps d'enveloppe (3) comporte un segment circulaire (53) sur la surface de fond (55) qui s'étend pratiquement par-dessus la même zone angulaire qu'un élément circulaire du moyen d'interdiction de rotation (31) non circulaire.

2. Ensemble formant enceinte selon la revendication 1, **caractérisé en ce que** la zone interface (11) du conduit (9) comprend une partie présentant une symétrie de rotation, en particulier une partie cylindrique.

3. Ensemble formant enceinte selon la revendication 1 ou la revendication 2, **caractérisé en ce que** le moyen d'interdiction de rotation (31) non circulaire présente une symétrie d'ordre trois, quatre, cinq ou six.

4. Ensemble formant enceinte selon l'une quelconque des revendications 1 à 3, **caractérisé en ce que** lesdits éléments circulaires (15) du moyen d'interdiction de rotation (31) non circulaire sont disposés selon un anneau, quatre desdites protubérances (33) étant disposées de façon équidistante l'une par rapport à l'autre.

5. Ensemble formant enceinte selon l'une quelconque des revendications 1 à 4, **caractérisé en ce qu'il** comprend en outre un organe élastique (19), en particulier un ressort.

6. Ensemble formant enceinte comprenant en outre un organe de réception à attache autobloquante (23),
**caractérisé en ce que** le moyen d'interdiction de rotation (31) non circulaire et l'organe de réception à attache autobloquante (23) sont configurés et disposés de sorte à présenter une position prédéterminée l'un par rapport à l'autre, en particulier à l'état où l'orifice d'entrée de câble amovible est monté dans le corps d'enveloppe (3), l'organe de réception à attache autobloquante étant pratiquement parallèle à l'une des surfaces du corps d'enveloppe.

7. Ensemble formant enceinte selon l'une quelconque des revendications 1 à 6, **caractérisé en ce que** le moyen d'interdiction de rotation (67) non circulaire comprend des éléments d'interdiction de rotation (69a, 69b, 69c, 69d) à bords rectilinéaires dans le plan perpendiculaire à l'axe de rotation (Ox).

8. Ensemble formant enceinte selon l'une quelconque des revendications 1 à 7, dont la zone interface (11) de l'orifice d'entrée de câble (25) est montée sur ou dans la zone interface appariée (13) de l'enveloppe afin de guider des faisceaux de câbles depuis l'extérieur de l'enveloppe dans l'espace intérieur du corps d'enveloppe (3).

9. Ensemble formant enceinte selon l'une quelconque des revendications précédentes, **caractérisé en ce que** le moyen d'interdiction de rotation (31) non circulaire de l'orifice d'entrée de câble (25) amovible est positionné à l'intérieur du corps d'enveloppe (3) et/ou à l'extrémité de la zone interface à l'extérieur du corps d'enveloppe (3).

10. Ensemble formant enceinte selon l'une quelconque des revendications précédentes, dont au moins deux desdits orifices d'entrée de câble (63, 65) amovibles sont montés sur ou dans deux zones interface appariées (13) adjacentes, **caractérisé en ce que** les moyens d'interdiction de rotation (67, 71) non circulaires des orifices d'entrée de câble (63, 65) amovibles adjacents sont configurés et agencés de sorte à ce que le moyen interdiction de rotation (67) non circulaire du premier orifice d'entrée de câble (63) soit placé au moins partiellement sur la trajectoire de rotation (75) du moyen d'interdiction de rotation (71) non circulaire de l'autre orifice d'entrée de câble (65).
